# EUROPEAN PATENT APPLICATION

(11) **EP 4 693 883 A1**
(43) Date of publication of application: **11.02.2026**
(21) Application number: 25194950.9
(22) Date of filing: 08.08.2025
(51) Int. Cl.: H02P 6/08, B25F 5/00, H02M 7/5387, H02P 27/08, H10D 30/47, B24B 23/00

(54) **INTEGRATED POWER STAGES IN POWER TOOL MOTOR DRIVE**

(30) Priority: 09.08.2024 US 202463681232 P; 04.12.2024 US 202463727739 P
(71) Applicant: Milwaukee Electric Tool Corporation, Brookfield, WI 53005 (US)
(72) Inventor: TRUETTNER, Donald J, Waukesha, WI 53188 (US); OBERMANN, Timothy R, Waukesha, WI 53186 (US); FIELDBINDER, Douglas R, Greendale, WI 53129 (US); STRANDT, Andrew P, New Berlin, WI 53151 (US)
(74) Representative: Forresters IP LLP

(57) **Abstract**

A motor drive for a motor of a power tool. The motor drive may include a motor, a power input, a switching network, and an electronic controller. The switching network is electrically connected to the power input and the motor. The switching network includes an integrated circuit. The integrated circuit includes a switching element and a gate driver for the switching element. The electronic controller electrically connected to the switching network. The electronic controller controls, by providing a control signal to the switching network, operation of the motor.

## Description

### RELATED APPLICATIONS

This application claims the benefit of U.S. Provisional Patent Application No. 63/681,232 filed on August 9, 2024 and U.S. Provisional Patent Application No. 63/727,739, filed December 4, 2024, the entire content of each of which is incorporated herein by reference.

### FIELD

The present disclosure relates to a motor drive of a power tool.

### SUMMARY

One embodiment provides a motor drive for a motor of a power tool, the motor drive including: a motor; a power input; a switching network electrically connected to the power input and the motor, the switching network including: an integrated circuit including a switching element and a gate driver for the switching element; and an electronic controller electrically connected to the switching network, the controller configured to: control, by providing a control signal to the switching network, operation of the motor.

One embodiment provides a motor drive for a motor of a power tool, the motor drive including: a power source; a switching network electrically connected to the power source, the switching network includes an integrated circuit including a switching element and a gate driver for the switching element; at least one output terminal electrically connected to the switching network; and an electronic controller electrically connected to the power source and communicatively connected to the switching network, the controller configured to: control, by providing a control signal to the switching network, operation of the switching element.

One embodiment provides a motor drive for a motor of a power tool, the motor drive including: a power source; and a switching network electrically connected to the power source, the switching network includes an integrated circuit including a switching element and a gate driver for the switching element, an input terminal electrically connected to the gate driver for the switching element, the input terminal configured to receive a control signal and provide the control signal to the gate driver, where the gate driver controls operation of the switching element, and an output terminal electrically connected to the switching network, the output terminal configured to provide an output of the switching element to a motor.

In some aspects, the techniques described herein relate to a power tool including: a motor; a power input; a switching network electrically connected between the power input and the motor, the switching network including an integrated circuit including a switching element and a gate driver for the switching element; and an electronic controller electrically connected to the switching network and configured to operate the motor by providing control signals to the integrated circuit.

In some aspects, the techniques described herein relate to a motor drive for a power tool, the motor drive including: a power bus; a switching network electrically connected to the power bus and including an integrated circuit including a switching element and a gate driver for the switching element; and an electronic controller electrically connected to the switching network and configured to operate the switching element by providing control signals to the integrated circuit.

In some aspects, the techniques described herein relate to a power tool including: a brushless direct current (BLDC) motor; a power input; a first integrated circuit electrically connected between a phase terminal of the BLDC motor and the power input, the first integrated circuit including a first Gallium Nitride (GaN) field effect transistor (FET) and a first gate driver for the first GaN FET a second integrated circuit electrically connected between the phase terminal of the BLDC motor and the power input and in parallel with the first integrated circuit, the second integrated circuit including a second GaN FET and a second gate driver for the second GaN FET; and an input circuit configured to receive a control signal from an electronic controller and provide the control signal to the first integrated circuit and the second integrated circuit.

Other aspects of the embodiments will become apparent by consideration of the detailed description and accompanying drawings.

### BRIEF DESCRIPTION OF THE DRAWINGS

FIG. 1 is a perspective view of a power tool, according to some embodiments.
FIG. 2 illustrates a battery pack, according to some embodiments.
FIG. 3 is a simplified block diagram of a control system of the power tool of FIG. 1, according to some embodiments.
FIG. 4 is a simplified block diagram of the power tool including a power circuit of the power tool, according to some embodiments.
FIG. 5A illustrates an example schematic of a wide bandgap transistor of the transistors illustrated in FIG. 4, according to some embodiments.
FIG. 5B illustrates an example schematic of a parallel configuration of the wide bandgap transistor illustrated in FIG. 5A, according to some embodiments.
FIG. 5C illustrates an example schematic of a first integrated circuit (IC) configuration of the integrated circuit illustrated in FIG. 4, according to some embodiments.
FIG. 5D illustrates an example schematic of a second IC configuration of the integrated circuit illustrated in FIG. 4, according to some embodiments.
FIG. 6A illustrates one example embodiment of a first configuration of the second IC configuration illustrated in FIG. 5D, according to some embodiments.
FIG. 6B illustrates one example embodiment of a second configuration 620 the second IC configuration illustrated in FIG. 5D, according to some embodiments.
FIG. 6C illustrates one example embodiment of a third configuration using the second IC configuration illustrated in FIG. 5D, according to some embodiments.
FIG. 7 illustrates one example embodiment of a first switching network configuration for the switching network 350, according to some embodiments.

Before any embodiments are explained in detail, it is to be understood that the embodiments are not limited in their application to the details of construction and the arrangement of components set forth in the following description or illustrated in the following drawings. The embodiments are capable of being practiced or of being carried out in various ways. Also, it is to be understood that the phraseology and terminology used herein is for the purpose of description and should not be regarded as limited. The use of "including," "comprising" or "having" and variations thereof herein is meant to encompass the items listed thereafter and equivalents thereof as well as additional items. The terms "mounted," "connected" and "coupled" are used broadly and encompass both direct and indirect mounting, connecting and coupling. Further, "connected" and "coupled" are not restricted to physical or mechanical connections or couplings, and can include electrical connections or couplings, whether direct or indirect. Additionally, unless otherwise noted, terms of approximation, such as "about," approximately," and "substantially," at least when used with numerical values, may refer to within 1%, 2.5%, 5%, or 10% of the noted value.

### DETAILED DESCRIPTION

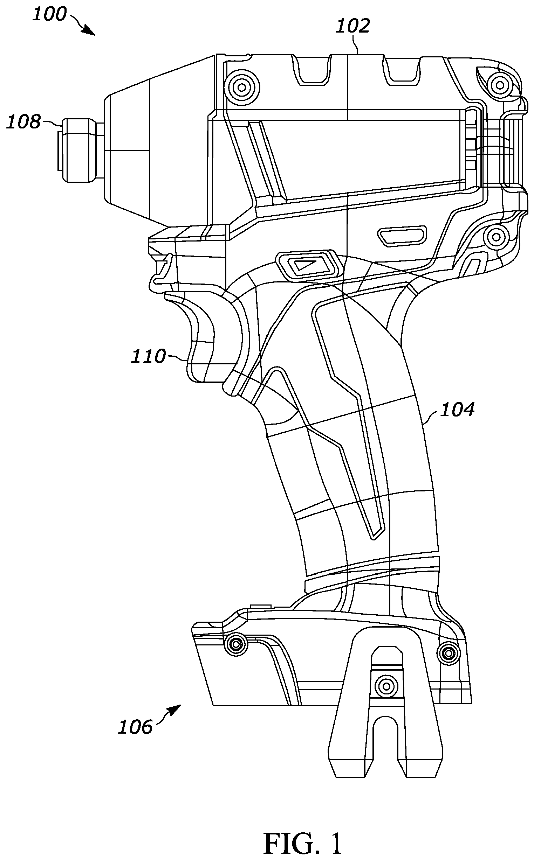

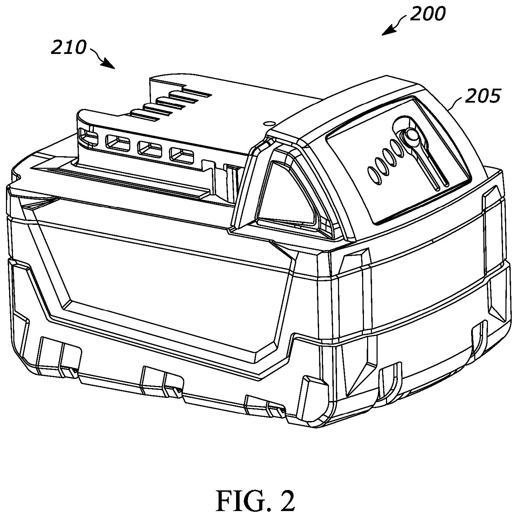

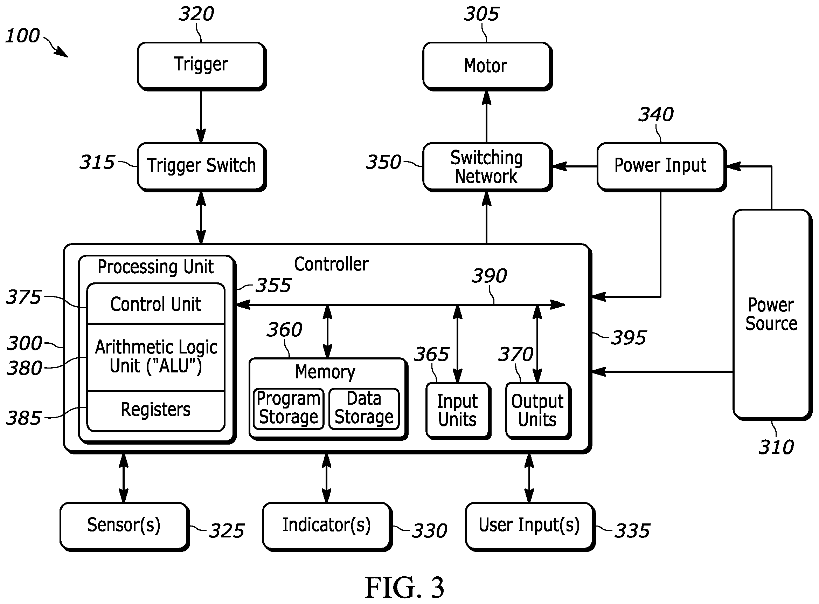

FIG. 1 illustrates an embodiment of a power tool 100 including a brushless direct current ("BLDC") motor. The power tool 100 is, for example, an impact driver including an upper main body 102, a handle 104, a battery pack receiving portion 106, an output drive device or mechanism 108, and a trigger 110. The power tool 100 further includes a motor, such as motor 305 (FIG. 3) within the main body 102 of the housing and having a rotor and a stator. The rotor is coupled to a motor shaft arranged to produce an output outside of the housing via the output drive device or mechanism 108. The housing of the power tool 100 (e.g., the main body 102 and the handle 104) are composed of a durable and light-weight plastic material. The drive device 108 is composed of a metal (e.g., steel) output spindle. The battery pack receiving portion 106 is configured to receive and couple to a battery pack, such as a battery pack 200 (FIG. 2) that provides power to the power tool 100. The battery pack receiving portion 106 includes a connecting structure to engage a mechanism that secures the battery pack and a terminal block to electrically connect the battery pack 200 to the power tool 100. In some embodiments, the power tool 100 may be an alternating current (AC) powered power tool that includes a rectifier to provide a DC voltage to the motor 305.

FIG. 1 illustrates an impact wrench, however, the power tool 100 may include drills, circular saws, jig saws, band saws, reciprocating saws, screw drivers, angle grinders, straight grinders, hammers, multi-tools, impact wrenches, rotary hammers, impact drivers, angle drills, powered ratchets, powered torque wrenches, hydraulic pulse tools, hydraulic tensioning tools, lock bolt installation tools, reaction arm tools, riveting tools, nailers, staplers, TC bolt guns, portable power source that converts battery power to AC output using an inventor, and the like.

FIG. 2 illustrates a battery pack 200, according to some embodiments. The battery pack 200 is a power tool battery pack that is generally used to power a power tool, such as the power tool 100. The battery pack 200 includes a housing 205 and an interface portion 210 for connecting the battery pack 200 to a device (e.g., the power tool 100). In some embodiments, the battery pack 200 includes lithium-ion battery cells. In other embodiments, the battery pack 200 may be of a different chemistry, for example, nickel-cadmium, nickel-metal hydride, and the like. In the illustrated embodiment, the battery pack 200 is an 18-volt battery pack. In other embodiments, the output voltage level of the battery pack 200 may be different. For example, the battery pack 200 can be a 4-volt battery pack, 28-volt battery pack, 36-volt battery pack, 72-volt battery pack or another voltage (voltage here may refer to nominal voltage). The battery pack 200 may also have various capacities (e.g., 3, 4, 5, 6, 8, or 12 ampere-hours).

The battery pack 200 also includes terminals to connect to the power tool 100. The terminals for the battery pack 200 includes a positive and a negative terminal to provide power to and from the battery pack 200. In some embodiments, the battery pack 200 also includes data terminals to communicate with the power tool 100. For example, the battery pack 200 may include a microcontroller to monitor one or more characteristics of the battery pack 200 and the data terminals may communicate with the power tool 100 regarding the monitored characteristics.

FIG. 3 is a simplified block diagram of a control system of the power tool 100 of FIG. 1, according to some embodiments. The control system includes a controller 300. The controller 300 is electrically and/or communicatively connected to a variety of modules or components of the power tool 100. For example, the illustrated controller 300 is electrically connected to a motor 305, a power source 310, a trigger switch 315 (connected to a trigger 320), one or more sensors or sensing circuits 325, one or more indicators 330, a user input module 335, a power input module 340, a switching network 350 (e.g., including a single switch for a brushed motor or a plurality of switches for a brushless motor). The controller 300 includes combinations of hardware and software that are operable to, among other things, control the operation of the power tool 100, monitor the operation of the power tool 100, activate the one or more indicators 330 (e.g., an LED), etc.

The controller 300 includes a plurality of electrical and electronic components that provide power, operational control, and protection to the components and modules within the controller 300 and/or the power tool 100. For example, the controller 300 includes, among other things, a processing unit 355 (e.g., a microprocessor, a microcontroller, or another suitable programmable device), a memory 360, input units 365, and output units 370. The processing unit 355 includes, among other things, a control unit 375, an ALU 380, and a plurality of registers 385 (shown as a group of registers in FIG. 3) and is implemented using a known computer architecture (e.g., a modified Harvard architecture, a von Neumann architecture, etc.). The processing unit 355, the memory 360, the input units 365, and the output units 370, as well as the various modules or circuits connected to the controller 300 are connected by one or more control and/or data buses (e.g., common bus 390). The control and/or data buses are shown generally in FIG. 3 for illustrative purposes. The use of one or more control and/or data buses for the interconnection between and communication among the various modules, circuits, and components would be known to a person skilled in the art in view of the invention described herein.

The memory 360 is a non-transitory computer readable medium and includes, for example, a program storage area and a data storage area. The program storage area and the data storage area can include combinations of different types of memory, such as a ROM, a RAM (e.g., DRAM, SDRAM, etc.), EEPROM, flash memory, a hard disk, an SD card, or other suitable magnetic, optical, physical, or electronic memory devices. The processing unit 355 is connected to the memory 360 and executes software instructions that are capable of being stored in a RAM of the memory 360 (e.g., during execution), a ROM of the memory 360 (e.g., on a generally permanent basis), or another non-transitory computer readable medium such as another memory or a disc. Software included in the implementation of the power tool 100 can be stored in the memory 360 of the controller 300. The software includes, for example, firmware, one or more applications, program data, filters, rules, one or more program modules, and other executable instructions. The controller 300 is configured to retrieve from the memory 360 and execute, among other things, instructions related to the control processes and methods described herein. In other constructions, the controller 300 includes additional, fewer, or different components.

In some embodiments, the power tool 100 includes a battery pack interface including a combination of mechanical components (e.g., rails, grooves, latches, etc.) and electrical components (e.g., one or more terminals) configured to and operable for interfacing (e.g., mechanically, electrically, and communicatively connecting) the power tool 100 with the power source 310 (e.g., the battery pack 200). For example, power provided by the battery pack 200 to the power tool 100 is provided through the battery pack interface to the power input module 340. The power input module 340 includes combinations of active and passive components to regulate or control the power received from the battery pack 200 prior to power being provided to the controller 300. The battery pack interface also supplies power via the power input module 340 to the switching network 350 provide power to the motor 305. The battery pack interface also includes, for example, a communication line 395 for providing a communication line or link between the controller 300 and the battery pack 200.

The indicators 330 include, for example, one or more light-emitting diodes ("LEDs"). The indicators 330 can be configured to display conditions of, or information associated with, the power tool 100. For example, the indicators 330 are configured to indicate measured electrical characteristics of the power tool 100, the status of the power tool 100, etc. The user input module 335 is operably coupled to the controller 300 to, for example, select a forward mode of operation or a reverse mode of operation, a torque and/or speed setting for the power tool 100 (e.g., using torque and/or speed switches), etc. In some embodiments, the user input module 335 includes a combination of digital and analog input or output devices required to achieve a desired level of operation for the power tool 100, such as one or more knobs, one or more dials, one or more switches, one or more buttons, etc.

The switching network 350 controls the motor 305 based on control signals from a motor controller, such as the controller 300. The switching network 350 includes a plurality of electronic switches (e.g., FETs, bipolar transistors, and the like) connected together to form a network that controls the activation of the motor 305 using a pulse-width modulated (PWM) signal. For instance, the switching network 350 may receive PWM signals from the controller 300 to drive the motor 305. Generally, when the trigger 320 is depressed, electrical current is supplied from the power source 310 to the motor 305 via the switching network 350. When the trigger 320 is not depressed, electrical current is not supplied from the power source 310 to the motor 305. For example, a trigger pull sensor senses the amount that the trigger 320 is pulled and the force with which the trigger 320 is pulled. In some examples, the output of the switching network 350 is provided to an AC outlet to power an AC device.

The motor 305 may be energized based on a state of the trigger 320. Generally, when the trigger 320 is activated, the motor 305 is energized, and when the trigger 320 is deactivated, the motor 305 is de-energized. In the illustrated embodiment, the trigger 320 may be biased (e.g., with a biasing member such as a spring) such that the trigger 320 moves in a second direction away from the handle of the power tool 100 when the trigger 320 is released by the user. In some embodiments, the controller 300 determines a shutdown condition of the power tool 100 based on the trigger pull sensor. For example, the controller 300 may determine that the power tool 100 is no longer being operated based on a lack of input from the trigger pull sensor and/or a release of the trigger pull sensor for a predetermined amount of time.

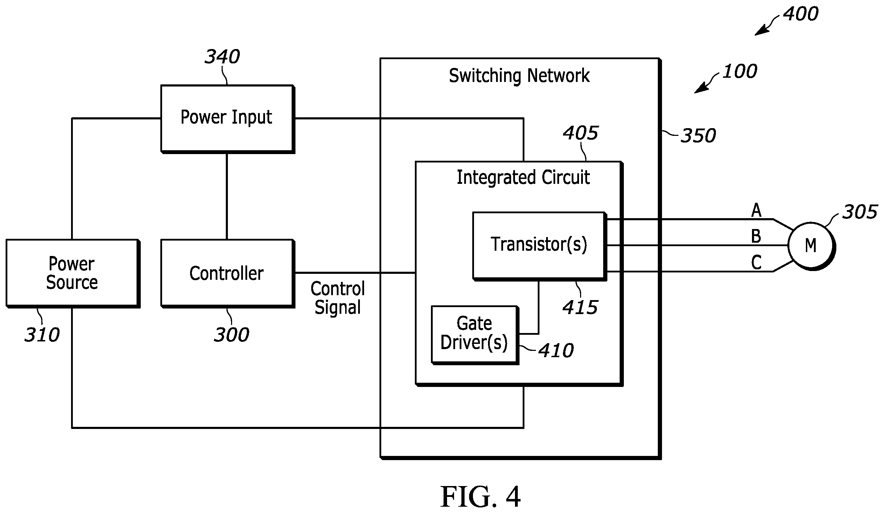

FIG. 4 is a simplified block diagram of the power tool 100 including a power circuit 400 of the power tool 100, according to some embodiments. The circuit 400 includes the controller 300, the motor 305, the power source 310, the power input 340, the switching network 350. The power source 310 is electrically connected to the power input 340. The power source 310 provides direct current (DC) operating voltage to the power input 340, which is then provided to the motor 305 (e.g., motor coils) through the switching network 350 that is controlled by the controller 300. Alternatively, in some embodiments, the power source 310 is an AC power source and a rectifier is provided in the power input 340 that turns AC power into DC power that is provided to the controller 300 and the switching network 350. The power input 340 is electrically connected to the controller 300 and the switching network 350. In some embodiments, the power input 340, the controller 300, and the switching network 350 are electrically and communicatively connected via a shared bus (not labeled). For example, the shared bus includes a power bus that includes a positive bus and a negative bus. In this example, the power input 340 is connected to the switching network 350 via the shared bus. In some embodiments, the controller 300 is the controller for the whole power tool 100 (e.g., there is only a single controller in the power tool 100). Alternatively or in addition, in some embodiments, the power circuit 400 includes a housekeeping power supply to provide power to components that may not be directly involved in the main function of the power circuit 400, such as control circuitry, monitoring systems, or protection mechanisms. Alternatively, in some embodiments, the controller 300 is specific to the power circuit 400, and in particular to the switching network 350.

The switching network 350 is electrically connected to the motor 305. In some embodiments, the motor 305 is a brushless DC (BLDC) motor. In some embodiments, the power source 310 is a battery pack, such as the battery pack 200. The switching network 350 is also electrically and communicatively connected to the controller 300. The switching network 350 includes at least one integrated circuit 405. The integrated circuit is an electronic device composed of multiple interconnected electronic components. The integrated circuit 405 is electrically connected to the power input 340. The integrated circuit 405 is configured to receive control signals from the controller 300 and control operation of the motor 305. The integrated circuit 405 may include at least one gate driver 410 and at least one transistor 415. The gate driver 410 is electrically connected to the transistor 415. The gate driver 410 activates the transistor 415 based on input from the controller 300. In some embodiments, the gate driver 410 is a power amplifier that receives a low-power input from the power source 310, via the controller 300 and produces a high-current drive input for the transistor 415.

In some embodiments, the gate driver 410 provides pulse width modulated (PWM) signals to the transistor 415 to switch the transistor 415 at a particular frequency with a particular duty cycle. Alternatively, in some embodiments, the gate driver 410 may send an ON signal to the transistor 415 so that it remains ON. When the transistor 415 is ON, the motor 305 receives current from the power source 310. For example, the current flowing through the transistor 415 flow into pole A (e.g., phase terminal), pole B, or pole C of the motor 305.

In some embodiments, the transistor 415 is a wide bandgap semiconductor field effect transistor (FET), such as an enhancement mode high electron mobility transistor (E-HEMT)). Wide bandgap semiconductor FETs are made from, for example, Gallium Nitrite (GaN) (e.g., GaN FETs or GaN E-HEMT, Silicon Carbide (SiC), or the like, and have bandgaps in the range of, for example, about 3 - 4 electronvolts (eV). Wide bandgap semiconductors exhibit several properties that provide advantages compared to traditional field-effect transistors (FETs) (e.g., MOSFETS). Particularly, wide bandgap semiconductors can be operated at very high frequencies, for example, at 100 kHz, 200kHz, 400 kHz, and more while losing less energy as heat than MOSFETs operating at lower frequencies, for example, 25 kHz, 50 kHz, and the like. Wide bandgap semiconductors have low on-state losses, smaller size, faster switching speed, and less or no reverse recovery, compared to traditional FETs. The wide bandgap semiconductors provide higher efficiency operation resulting in improved runtime for battery powered power tools, such as, for example, the power tool 100.

Because the wide bandgap semiconductor transistors can be operated at very high frequencies, the transistor 415 provides higher resolution signals at the outputs. Specifically, the switching frequency can be extended to above the human threshold of hearing (e.g., greater than 20 kHz to approximately 100 kHz) which an reduce the audio discomfort to the user during operation. Energy storage capacity can be reduced for the same total output energy rating caused by the increased frequency during operation of the wide bandgap semiconductors compared to MOSFETs. Additionally, smaller heat sinks and fans can be used because the wide bandgap semiconductors operate more efficiently than MOSFETs and therefore produce less heat during operation. Accordingly, the size and weight of the components within the power tool 100 can be reduced and efficiency can be improved of the power circuit 400 by replacing MOSFETs with wide bandgap semiconductor devices within the switching network 350. The switching network 350 and the integrated circuit 405 are not limited to the configuration and arrangement of components set forth illustrated embodiment. The switching network 350 configuration and the integrated circuit 405 will be described in greater detail below. Unlike in traditional MOSFET transistors, the high switching frequency of the wide bandgap semiconductors may also provide small dead time (e.g., 100 nanoseconds or less) between switching a switch from one state to the next. In some instances, decreasing an amount of time between activation and deactivation (i.e., dead time) of both switching elements in half bridge configuration of the one or more integrated circuits reduces the harmonic content of a motor phase current, which increases conversion efficiency.

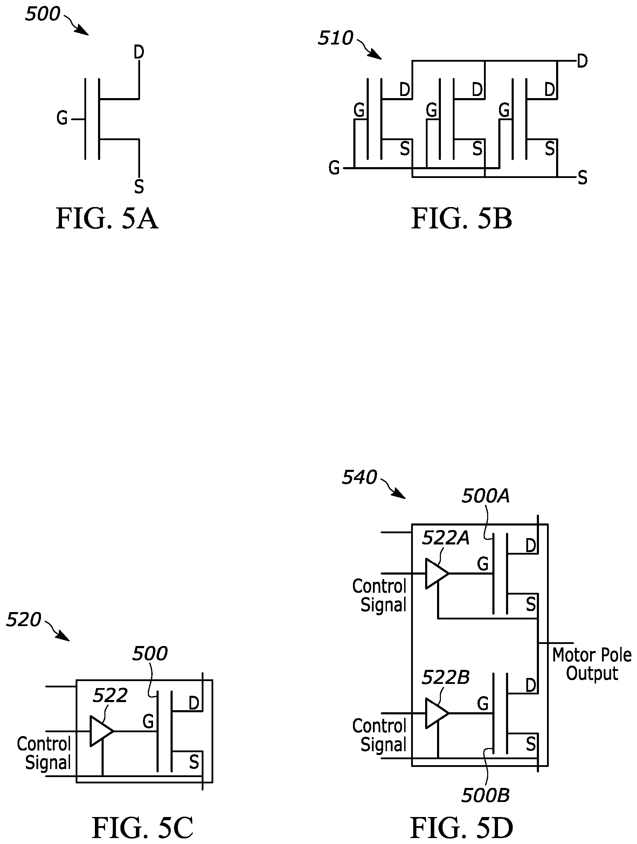

FIG. 5A illustrates an example schematic of a discrete single element wide bandgap transistor 500 of the transistors 415 for the power circuit 400 illustrated in FIG. 4, according to some embodiments. The wide bandgap transistor 500 is a GaN (Gallium Nitride) Enhancement mode High Electron Mobility Transistor (HEMT) is a type of transistor (e.g., GaN FET) used in power electronic devices, or the like. The wide bandgap transistor 500 is a three-terminal device with a source (S), drain (D), and gate (G). The structure of the wide bandgap transistor 500 may consist of a thin GaN layer sandwiched between two layers of AlGaN (Aluminum Gallium Nitride). For example, the GaN layer acts as a channel for electrons to flow from source (S) to drain (D). The AlGaN layer acts as a barrier, reducing the electron density in the channel, allowing for better control of electron flow. The GaN HEMT is an enhancement mode transistor, which means that the gate voltage needs to be applied to the device to create a conductive channel in the GaN layer for current to flow from source to drain. The GaN HEMT has a high electron mobility, which means that electrons can move faster in the channel, resulting in a higher current density than traditional silicon MOSFET devices. FIG. 5A illustrates an example of an integrated circuit including only a single GaN FET (referred to as a discrete GaN FET). In the example of FIG. 5A, the integrated circuit does not include a gate driver.

FIG. 5B illustrates an example schematic of a parallel configuration 510 of the wide bandgap transistor 500 illustrated in FIG. 5A, according to some embodiments. The parallel configuration 510 includes three (3) wide bandgap transistors 500 connected in parallel. The drains (D) of the wide bandgap transistors 500 are connected to one another. The sources (S) of the wide bandgap transistors 500 are connected to one another. The wide bandgap transistors 500 may be driven by provided at a gate signal at the gates (G) of the wide bandgap transistors 500. Discrete GaN FETs are usually rated in terms of blocking voltage and on-state resistance. The amount of power that can be processed by the GaN FET may be limited by the power dissipated (e.g., conduction loss) in the GaN FET. The power loss that the GaN FET generates is due to the on-state resistance. GaN FETs arranged in a parallel configuration will reduce the power loss by reducing the on-state resistance by a factor of 1/n (where n is the number of parallel connected GaN FETs) similar to a linear resistor. FIG. 5A illustrates one such example of parallel configuration of discrete GaN FETs. In the example illustrated, three GaN FETs placed in parallel result in reducing the on-state resistance to a third of the on-state resistance of the discrete GaN FET of FIG. 5A.

FIG. 5C illustrates an example schematic of a first integrated circuit (IC) configuration 520 of the integrated circuit 405 for the power circuit 400 illustrated in FIG. 4, according to some embodiments. The first IC configuration 520 includes a transistor driver 522 (i.e., gate driver) and the wide bandgap transistor 500 described in FIG. 5A. The transistor driver 522 electrically connected to the gate (G) of the wide bandgap transistor 500. The transistor driver 522 configured to receive a control signal from a controller, such as the controller 300, and send an ON signal to the wide bandgap transistor 500. The gate of the wide bandgap transistor 500 is connected to the transistor driver 522. The first IC configuration 520 includes a source terminal connected to a source of the wide bandgap transistor 500. The first IC configuration 520 includes a drain terminal connected to a drain of the wide bandgap transistor 500. The first IC configuration 520 includes a drive terminal connected to the transistor driver 522 of the wide bandgap transistor 500. The first IC configuration 520 includes a control terminal for providing a control signal to the transistor driver 522 of the wide bandgap transistor 500. The control terminal is connected to an output pin of the electronic controller 300 to receive a control signal. The first IC configuration 520 also includes a power supply terminal for receiving, from to the power input 340, a control power supply to operate the transistor driver 522 of the wide bandgap transistor 500. In some instances, the drive terminal is connected to the power input 340 and the source terminal is connected to a motor output terminal. In other instances, the source terminal is connected to the power input 340 and the drive terminal is connected to a motor output terminal.

FIG. 5D illustrates an example schematic of a second IC configuration 540 of the integrated circuit 405 for the power circuit 400 illustrated in FIG. 4, according to some embodiments. The second IC configuration 540 includes a first transistor driver 522A and a second transistor driver 522B (hereinafter "the drivers 522") as described in FIG. 5C and a first wide bandgap transistor 500A and a second wide bandgap transistor 500B (hereinafter "the transistors 500", that is, transistor switches) described in FIG. 5A. The drivers 522 electrically connected to the gates (G) of the transistors 500 respectively. The drivers 522 configured to receive a control signal from a controller, such as the controller 300, and send an ON signal to the transistors 500. The source (S) of the first wide bandgap transistor 500A electrically connected to the drain (D) of the second wide bandgap transistor 500B. The second IC configuration 540 including a motor pole outlet between the source (S) of the first wide bandgap transistor 500A and the drain (D) of the second wide bandgap transistor 500B. The motor pole outlet electrically connected to a pole of a motor, such as the motor 305. In some embodiments, the first wide bandgap transistor 500A may be a high-side transistor and the second wide bandgap transistor 500B may be a low-side transistor. For example, the transistors 500 are configured as a half-bridge. In this example, a high-side transistor is electrically connected between a positive bus of the power input 340 and a plurality of terminals of the motor 305, and a low-side transistor is electrically connected between a negative bus of the power input 340 and the plurality of terminals of the motor 305. In addition, the switching network 350 includes a plurality of half-bridges. In some embodiments, the second IC configuration 540 includes a plurality of the transistors 500 including multiple of the first wide bandgap transistor 500A as high-side transistors and multiple of the second wide bandgap transistors 500B as low-side transistors. For example, the transistors 500 are configured as a full-bridge. In another example, the second IC configuration 540 includes twelve (12) of the transistors 500.

GaN FETs may be sensitive to perturbations in the gate drive signal. In one example, E-HEMT may need approximately 5 volts to fully conduct (with low loss) but may not tolerate more than 6 volts. For this reason, the signal routing from the gate driver to the power device may include very low inductive signal path. The more power devices driven from the same gate drive circuit, the more complicated the parallel connection of multiple GaN FETs may become.

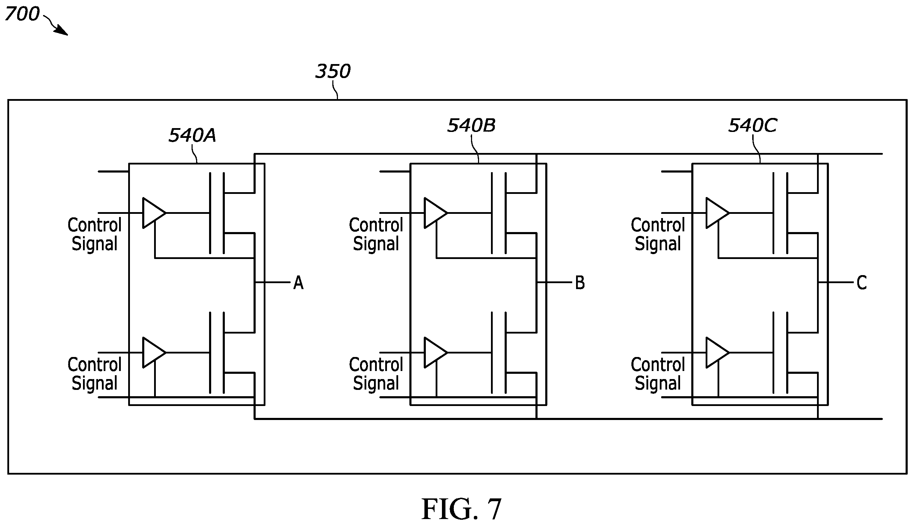

GaN FETs may be fabricated on a Silicon substrate to ease the burden of manufacturing, as a large infrastructure of Silicon integrated circuit manufacturing already exists. Silicon substrate manufacturing also allows for integration of other silicon-based circuits such as integrated gate drive, overtemperature detection, overcurrent detection, lossless current measurement, and short circuit detection among others. Most integrated GaN FETs facilitate easy implementation in electronic devices. A control power supply may be provided to the integrated circuit along with one or two gate signals. These gate signals may be conditioned by the integrated circuit and optimally routed to the GaN FET ensuring reliable operation. The output of this integrated GaN circuit can be either a single Drain connection (e.g., FIGS. 5A-5C) in the case of a single GaN FET or a single Source-Drain connection (e.g., FIG. 5D), sometimes called the pole of the inverter, in the case of two internal GaN FETs in the half-bridge configuration. These poles of the half bridge are then connected to the leads of the motor to comprise a motor drive. Because of the highly integrated nature of this power device (that is, the integrated circuit), the allowable power dissipated in this device is limited. Connecting several of half-bridges (e.g., FIG. 5D) in parallel as shown in FIG. 7 provides additional benefits for power dissipation.

Connecting the GaN Integrated Circuits in parallel (e.g., as shown in FIG. 7) may lead to sharing the load current through each GaN device (e.g., GaN FET or GaN IC). When paralleling power devices there are two components to current sharing: static and dynamic. Static current sharing is defined as how well parallel power devices share current when the device is fully conducting or "ON". Dynamic current sharing is defined as how well the parallel power devices share current when the devices are switching from blocking or "OFF" to conducting or "ON" and from conducting or "ON" to blocking or "OFF". One factor affecting static current sharing is the on-state resistance or RDS-on of the GaN device. Most E-HEMT exhibit a positive temperature coefficient on RDS-on. This means that as the device carrying the most current heats up, its RDS-on also increases, thus decreasing the amount of current flowing through the device. In this way the devices tend to self-balance when it comes to static current sharing.

Factors that affect dynamic current sharing include gate threshold, VGS(th), transconductance (Gm) and layout of the IC/device. VGS(th) is the level of voltage presented at the gate of the device where the device starts to turn on and conduct current. When considering parallel GaN devices (e.g., parallel connected GaN E-HEMT devices), the device with the lowest VGS(th) will turn on first. Transconductance can be thought of as the current gain rating of the GaN device and is the mechanism linking the applied gate voltage of the GaN device to the current it is able to conduct. In parallel GaN device configurations, individual device with the highest transconductance may conduct the most current. In GaN devices, transconductance has a negative temperature coefficient meaning that as the device heats up the transconductance or "current gain" decreases, thus reducing the amount of current that is being conducted by that device. The path of current taken between the gate driver and the GaN FET or as known in the art, the gate-source loop may also affect dynamic current sharing. For example, if the distance of a conductor between the gate driver and the GaN FET is different for two GaN FETs, then this leads to the GaN FET with the higher output experiencing an imbalance in current sharing, overheating, or premature failure. Due to the high-speed switching nature of GaN FETs, symmetry when connecting multiple devices to the same gate driver may help with dynamic current sharing. Having an integrated gate driver in the same IC as the GaN FET, makes it easier to achieve symmetry, for example, because there is no longer a need for additional routing of the connections between the gate driver and the GaN FET) and the gate-source loop is approximately the same for all GaN FETs because the GaN FETs come in a packages that are identical.

As discussed herein, to minimize dynamic current sharing, circuit can be combined with integrated GaN FETs (e.g., including GaN gate drivers) at the power stage input, power stage output, or both as shown below.

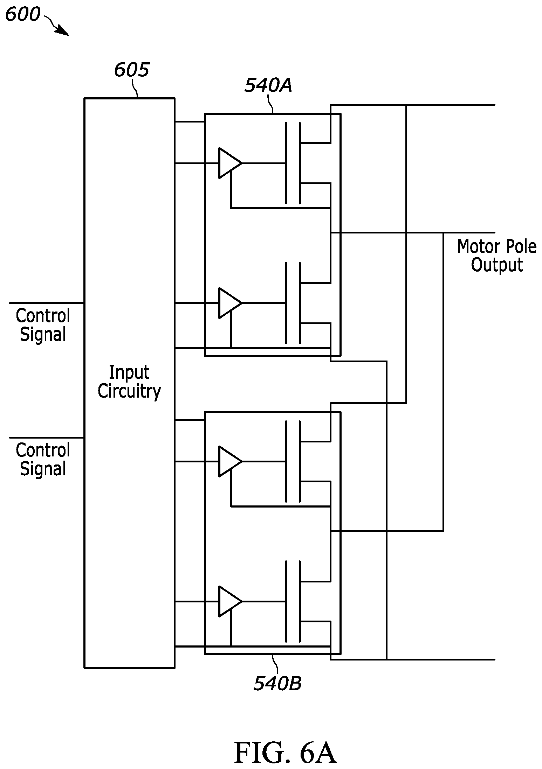

FIGS. 6A-6C illustrate techniques for reducing dynamic current sharing when multiple GaN FETs are connected in parallel between a power input and one terminal of the motor 305. FIG. 6A illustrates one example embodiment of a first configuration 600 of the second IC configuration 540 illustrated in FIG. 5D for the power circuit 400 illustrated in FIG. 4. The first configuration 600 includes an input circuitry 605 and two (2) instances of the second IC configuration 540, such as, for example, the second IC configuration 540A and the second IC configuration 540B. The input circuitry 605 is configured to receive control signals from a controller, such as the controller 300. The input circuitry 605 provides the control signals to the drivers 522. Specifically, the input circuitry 605 may receive a single signal to control both FETs of the first IC configuration 540A and a single signal to control both FETs of the second IC configuration 540B. The input circuit 605 may provide separate signals for each FET of the first IC configuration 540A and the second IC configuration 540B. The input circuitry 605 is also configured to provide power to the second IC configuration 540A and the second IC configuration 540B from a power source, such as the power source 310. The input circuitry may include, for example, an amplifier circuit that allows for amplifying and dividing the control signal that a single signal can be provided to two outputs. The input circuitry 605 minimizes the risk of dynamic current sharing in the paralleled integrated GaN power devices, such as the second IC configuration 540A and the second IC configuration 540B. The drivers 522 of the second IC configuration 540A and the second IC configuration 540B are configured to receive the control signals and control operation of the transistors 500 to provide an output that operates a motor, such as the motor 305. The second IC configuration 540A and the second IC configuration 540B each including a motor pole outlet between the source (S) and the drain (D) of the transistors 500, and the motor pole outlets of the second IC configuration 540A and the second IC configuration 540B are electrically connected to one another. Outputs from the motor pole outlets are provided to a pole of the motor, such as the motor 305. In some embodiments, the switching network 350 of FIG. 4 include the second IC configuration 540A and the second IC configuration 540B as configured in FIG. 6A.

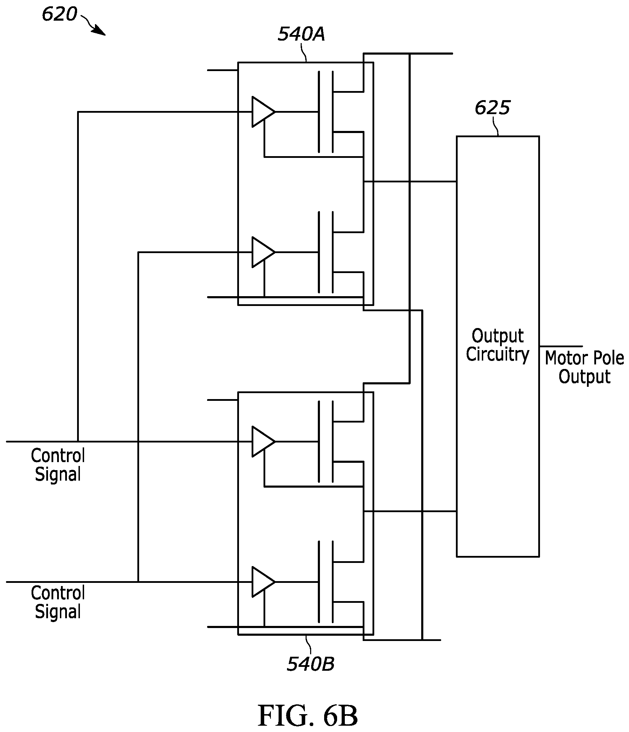

FIG. 6B illustrates one example embodiment of a second configuration 620 using the second IC configuration 540 illustrated in FIG. 5D for the power circuit 400 illustrated in FIG. 4. The second configuration 620 includes an output circuitry 625 and two (2) instances of the second IC configuration 540, such as, for example, the second IC configuration 540A and the second IC configuration 540B. The drivers 522 of the second IC configuration 540A and the second IC configuration 540B are configured to receive control signals from a controller, such as the controller 300. The drivers 522 control operation of the transistors 500 of the second IC configuration 540A and the second IC configuration 540B. The second IC configuration 540A and the second IC configuration 540B each including an output between the source (S) and the drain (D) of the transistors 500. The outputs of the second IC configuration 540A and the second IC configuration 540B are electrically connected to the output circuitry 625. The output circuitry 625 includes a motor pole output providing the outputs of the second IC configuration 540A and the second IC configuration 540B to a motor, such as the motor 305. The output circuitry 625 minimizes the risk of dynamic current sharing in the paralleled integrated GaN power devices, such as the second IC configuration 540A and the second IC configuration 540B.

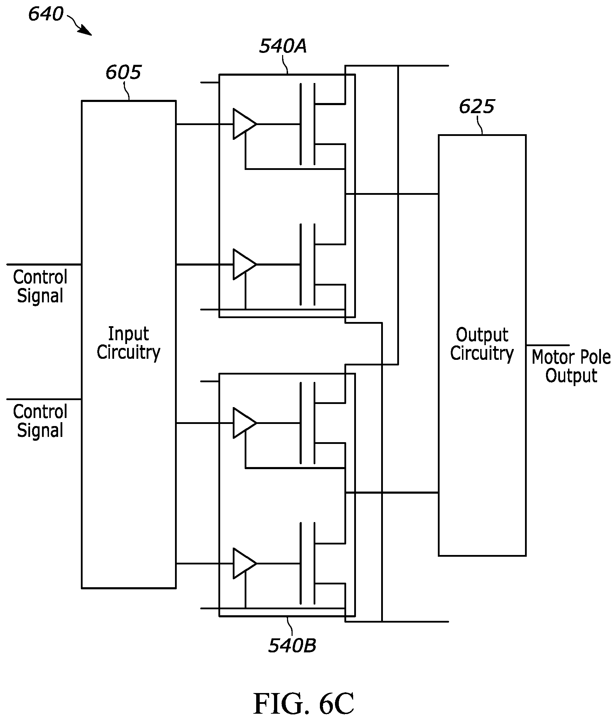

FIG. 6C illustrates one example embodiment of a third configuration 640 using the second IC configuration 540 illustrated in FIG. 5D for the power circuit 400 illustrated in FIG. 4. The third configuration 640 includes the input circuitry 605, the output circuitry 625, and two (2) instances of the second IC configuration 540, such as, for example, the second IC configuration 540A and the second IC configuration 540B. The input circuitry 605 is configured to receive control signals from a controller, such as the controller 300. The input circuitry 605 provides the control signals to the drivers 522. The input circuitry 605 is also configured to provide power to the second IC configuration 540A and the second IC configuration 540B from a power source, such as the power source 310. The drivers 522 of the second IC configuration 540A and the second IC configuration 540B are configured to receive the control signals and control operation of the transistors 500 to provide an output. The outputs of the second IC configuration 540A and the second IC configuration 540B are each provided between the source (S) and the drain (D) of the transistors 500. The outputs of the second IC configuration 540A and the second IC configuration 540B are electrically connected to the output circuitry 625. The output circuitry 625 includes a motor pole output providing the outputs of the second IC configuration 540A and the second IC configuration 540B to a motor, such as the motor 305.

FIG. 7 illustrates one example embodiment of a first switching network configuration 700 using the second IC configuration 540 illustrated in FIG. 5D for the switching network 350 illustrated in FIG. 4. The first switching network configuration 700 is three-phase inverter configuration. The first switching network configuration 700 includes the switching network 350. The switching network 350 includes three (3) instances of the second IC configuration 540 (e.g., six (6) switching elements), such as, for example, the second IC configuration 540A, the second IC configuration 540B, and a second IC configuration 540C. The drain (D) of the respective first wide bandgap transistors 500A of the second IC configuration 540A, the second IC configuration 540B, and the second IC configuration 540C connected to one another. The source (S) of the respective second wide bandgap transistors 500B of the second IC configuration 540A, the second IC configuration 540B, and the second IC configuration 540C electrically connected to one another. The common drain (D) and source (S) are connected to the battery pack positive and negative terminals respectively to receive power from the battery pack 200. The drivers 522 configured to receive a control signal from a controller, such as the controller 300, and send an ON signal to the transistors 500. The second IC configuration 540A, the second IC configuration 540B, and the second IC configuration 540C including a motor pole outlet between the source (S) of the respective first wide bandgap transistors 500A and the drain (D) of the respective second wide bandgap transistors 500B. The respective motor pole outlet of the second IC configuration 540A, the second IC configuration 540B, and the second IC configuration 540C are each electrically connected to a pole of a motor, such as the motor 305.

Thus, various embodiments described herein provide for power converter devices having wide bandgap semiconductors.

### REPRESENTATIVE FEATURES

Representative features are set out in the following clauses, which stand alone or may be combined, in any combination, with one or more features disclosed in the text and/or drawings of the specification.
1. A power tool comprising:
   a motor;
   a power input;
   a switching network electrically connected between the power input and the motor, the switching network including
      an integrated circuit including a switching element and a gate driver for the switching element; and
   an electronic controller electrically connected to the switching network and configured to operate the motor by providing control signals to the integrated circuit.
2. The power tool of clause 1, wherein the integrated circuit includes an output electrically connected to a terminal of the motor.
3. The power tool of clause 1, wherein the switching network is a three-phase inverter and includes a plurality of integrated circuits, the plurality of integrated circuits including three high-side switching elements and three low-side switching elements and corresponding plurality of gate drivers, wherein the integrated circuit is one of the plurality of integrated circuits, and wherein the switching element is one of the three high-side switching elements or the three low-side switching elements.
4. The power tool of clause 1, wherein the integrated circuit includes a drain terminal connected to a drain of the switching element, a source terminal connected to a source of the switching element, a control terminal connected to a control input of the gate driver, and a power supply terminal connected to a power supply input of the gate driver, wherein the control terminal is electrically connected to an output pin of the electronic controller, and the power supply terminal is electrically connected to a housekeeping power supply.
5. The power tool of clause 4, wherein the drain terminal is electrically connected to a positive bus of the power input and the source terminal is electrically connected to a motor terminal.
6. The power tool of clause 4, wherein the source terminal is electrically connected to a negative bus of the power input and the drain terminal is electrically connected to a motor terminal.
7. The power tool of clause **1,** wherein the integrated circuit is a first integrated circuit, wherein the switching element is a first high-side wide bandgap semiconductor field effect transistor (FET), wherein the gate driver is a first high-side gate driver,
   wherein the switching network is a the three-phase inverter including the first integrated circuit, a second integrated circuit, and a third integrated circuit,
   wherein the first integrated circuit further includes a first low-side wide bandgap semiconductor FET and a first low-side gate driver for the first low-side wide bandgap semiconductor FET,
   wherein the second integrated circuit includes a second high-side wide bandgap semiconductor FET, a second high-side gate driver for the second high-side wide bandgap semiconductor FET, a second low-side wide bandgap semiconductor FET, and a second low-side gate driver for the second low-side wide bandgap semiconductor FET, and
   wherein the third integrated circuit includes a third high-side wide bandgap semiconductor FET, a third high-side gate driver for the third high-side wide bandgap semiconductor FET, a third low-side wide bandgap semiconductor FET, and a third low-side gate driver for the third low-side wide bandgap semiconductor FET.
8. The power tool of clause 7, wherein the first integrated circuit includes a positive bus terminal, a negative bus terminal, a first control terminal for the first high-side gate driver, a second control terminal for the first low-side gate driver, a power supply terminal, and a pole terminal, the first high-side wide bandgap semiconductor FET is connected between the positive bus terminal and the pole terminal and the first low-side wide bandgap semiconductor FET is connected between the pole terminal and the negative bus terminal, and wherein the positive bus terminal is electrically connected to a positive bus of the power input and the negative bus terminal is electrically connected to negative bus of the power input.
9. The power tool of clause 7, further comprises:
   input circuitry electrically connected between the electronic controller and the switching network, the input circuitry configured to:
   receive control signals from the electronic controller and provide the control signals to the first integrated circuit, the second integrated circuit, and the third integrated circuit.
10. The power tool of clause 9, further comprises:
   output circuitry electrically connected between the switching network and the motor, the output circuitry configured to
   receive outputs from the first integrated circuit, the second integrated circuit, and the third integrated circuit and provide the outputs to the motor.
11. The power tool of clause 1, wherein the switching element is a Gallium Nitride Enhancement Mode High Electron Mobility Transistor (GaN E-HEMT).
12. The power tool of clause 1, wherein the switching network includes a plurality of integrated circuits connected in parallel between the power input and one terminal of the motor, wherein the plurality of integrated circuits includes the integrated circuit.
13. A motor drive for a power tool, the motor drive comprising:
   a power bus;
   a switching network electrically connected to the power bus and including
      an integrated circuit including a switching element and a gate driver for the switching element; and
   an electronic controller electrically connected to the switching network and configured to operate the switching element by providing control signals to the integrated circuit.
14. The motor drive of clause 13, wherein the switching network is a three-phase inverter and includes a plurality of integrated circuits, the plurality of integrated circuits including three high-side switching elements and three low-side switching elements and corresponding plurality of gate drivers, wherein the integrated circuit is one of the plurality of integrated circuits, and wherein the switching element is one of the three high-side switching elements or the three low-side switching elements.
15. The motor drive of clause 13, wherein the integrated circuit includes a drain terminal connected to a drain of the switching element, a source terminal connected to a source of the switching element, a control terminal connected to a control input of the gate driver, and a power supply terminal connected to a power supply input of the gate driver, wherein the control terminal is electrically connected to an output pin of the electronic controller, and the power supply terminal is electrically connected to a housekeeping power supply.
16. The motor drive of clause 15, wherein the drain terminal is electrically connected to a positive bus of the power bus and the source terminal is electrically connected to a phase terminal of a motor.
17. The motor drive of clause 15, wherein the source terminal is electrically connected to a negative bus of the power bus and the drain terminal is electrically connected to a phase terminal of a motor.
18. The motor drive of clause 13, wherein the integrated circuit is a first integrated circuit, wherein the switching element is a first high-side wide bandgap semiconductor field effect transistor (FET), wherein the gate driver is a first high-side gate driver,
   wherein the switching network is a the three-phase inverter including the first integrated circuit, a second integrated circuit, and a third integrated circuit,
   wherein the first integrated circuit further includes a first low-side wide bandgap semiconductor FET and a first low-side gate driver for the first low-side wide bandgap semiconductor FET,
   wherein the second integrated circuit includes a second high-side wide bandgap semiconductor FET, a second high-side gate driver for the second high-side wide bandgap semiconductor FET, a second low-side wide bandgap semiconductor FET, and a second low-side gate driver for the second low-side wide bandgap semiconductor FET, and
   wherein the third integrated circuit includes a third high-side wide bandgap semiconductor FET, a third high-side gate driver for the third high-side wide bandgap semiconductor FET, a third low-side wide bandgap semiconductor FET, and a third low-side gate driver for the third low-side wide bandgap semiconductor FET.
19. The motor drive of clause 18, wherein the first integrated circuit includes a positive bus terminal, a negative bus terminal, a first control terminal for the first high-side gate driver, a second control terminal for the first low-side gate driver, a power supply terminal, and a pole terminal, the first high-side wide bandgap semiconductor FET is connected between the positive bus terminal and the pole terminal and the first low-side wide bandgap semiconductor FET is connected between the pole terminal and the negative bus terminal, and wherein the positive bus terminal is electrically connected to a positive bus of the power bus and the negative bus terminal is electrically connected to negative bus of the power bus.
20. The motor drive of clause 18, further comprises:
   input circuitry electrically connected between the electronic controller and the switching network, the input circuitry configured to:
   receive control signals from the electronic controller and provide the control signals to the first integrated circuit, the second integrated circuit, and the third integrated circuit.
21. The motor drive of clause 13, wherein the switching element is a Gallium Nitride Enhancement Mode High Electron Mobility Transistor (GaN E-HEMT).
22. The motor of clause 13, wherein the switching network includes a plurality of integrated circuits connected in parallel between the power bus and one phase terminal of a motor, wherein the plurality of integrated circuits includes the integrated circuit.
23. A power tool comprising:
   a brushless direct current (BLDC) motor;
   a power input;
   a first integrated circuit electrically connected between a phase terminal of the BLDC motor and the power input, the first integrated circuit including a first Gallium Nitride (GaN) field effect transistor (FET) and a first gate driver for the first GaN FET
   a second integrated circuit electrically connected between the phase terminal of the BLDC motor and the power input and in parallel with the first integrated circuit, the second integrated circuit including a second GaN FET and a second gate driver for the second GaN FET; and
   an input circuit configured to receive a control signal from an electronic controller and provide the control signal to the first integrated circuit and the second integrated circuit.
24. The power tool of clause 23, wherein the first integrated circuit includes a drain terminal connected to a drain of the first GaN FET, a source terminal connected to a source of the first GaN FET, a control terminal connected to a control input of the gate driver, and a power supply terminal connected to a power supply input of the gate driver, wherein the control terminal is configured to receive the control signal from the input circuit, and the power supply terminal is electrically connected to a housekeeping power supply.
25. The power tool of clause 24, wherein the drain terminal is electrically connected to a positive bus of the power input and the source terminal is electrically connected to the phase terminal.
26. The power tool of clause 24, wherein the source terminal is electrically connected to a negative bus of the power input and the drain terminal is electrically connected to the phase terminal.
27. The power tool of clause 23, wherein the GaN FET is a Gallium Nitride Enhancement Mode High Electron Mobility Transistor (GaN E-HEMT).

## Claims

1. A power tool comprising:
a motor;
a power input;
a switching network electrically connected between the power input and the motor, the switching network including
an integrated circuit including a switching element and a gate driver for the switching element; and
an electronic controller electrically connected to the switching network and configured to operate the motor by providing control signals to the integrated circuit.

2. The power tool of claim **1,** wherein the integrated circuit includes an output electrically connected to a terminal of the motor.

3. The power tool of claim 1 or 2, wherein the switching network is a three-phase inverter and includes a plurality of integrated circuits, the plurality of integrated circuits including three high-side switching elements and three low-side switching elements and corresponding plurality of gate drivers, wherein the integrated circuit is one of the plurality of integrated circuits, and wherein the switching element is one of the three high-side switching elements or the three low-side switching elements.

4. The power tool of any preceding claim, wherein the integrated circuit includes a drain terminal connected to a drain of the switching element, a source terminal connected to a source of the switching element, a control terminal connected to a control input of the gate driver, and a power supply terminal connected to a power supply input of the gate driver, wherein the control terminal is electrically connected to an output pin of the electronic controller, and the power supply terminal is electrically connected to a housekeeping power supply,
preferably wherein the drain terminal is electrically connected to a positive bus of the power input and the source terminal is electrically connected to a motor terminal, and/or wherein the source terminal is electrically connected to a negative bus of the power input and the drain terminal is electrically connected to a motor terminal.

5. The power tool of any preceding claim, wherein the integrated circuit is a first integrated circuit, wherein the switching element is a first high-side wide bandgap semiconductor field effect transistor (FET), wherein the gate driver is a first high-side gate driver,
wherein the switching network is a the three-phase inverter including the first integrated circuit, a second integrated circuit, and a third integrated circuit,
wherein the first integrated circuit further includes a first low-side wide bandgap semiconductor FET and a first low-side gate driver for the first low-side wide bandgap semiconductor FET,
wherein the second integrated circuit includes a second high-side wide bandgap semiconductor FET, a second high-side gate driver for the second high-side wide bandgap semiconductor FET, a second low-side wide bandgap semiconductor FET, and a second low-side gate driver for the second low-side wide bandgap semiconductor FET, and
wherein the third integrated circuit includes a third high-side wide bandgap semiconductor FET, a third high-side gate driver for the third high-side wide bandgap semiconductor FET, a third low-side wide bandgap semiconductor FET, and a third low-side gate driver for the third low-side wide bandgap semiconductor FET,
preferably wherein the first integrated circuit includes a positive bus terminal, a negative bus terminal, a first control terminal for the first high-side gate driver, a second control terminal for the first low-side gate driver, a power supply terminal, and a pole terminal, the first high-side wide bandgap semiconductor FET is connected between the positive bus terminal and the pole terminal and the first low-side wide bandgap semiconductor FET is connected between the pole terminal and the negative bus terminal, and wherein the positive bus terminal is electrically connected to a positive bus of the power input and the negative bus terminal is electrically connected to negative bus of the power input.

6. The power tool of claim 5, further comprises:
input circuitry electrically connected between the electronic controller and the switching network, the input circuitry configured to:
receive control signals from the electronic controller and provide the control signals to the first integrated circuit, the second integrated circuit, and the third integrated circuit,
preferably wherein the power toolfurther comprises:
output circuitry electrically connected between the switching network and the motor, the output circuitry configured to
receive outputs from the first integrated circuit, the second integrated circuit, and the third integrated circuit and provide the outputs to the motor.

7. The power tool of any preceding claim, wherein the switching element is a Gallium Nitride Enhancement Mode High Electron Mobility Transistor (GaN E-HEMT), and/or wherein the switching network includes a plurality of integrated circuits connected in parallel between the power input and one terminal of the motor, wherein the plurality of integrated circuits includes the integrated circuit.

8. A motor drive for a power tool, the motor drive comprising:
a power bus;
a switching network electrically connected to the power bus and including
an integrated circuit including a switching element and a gate driver for the switching element; and
an electronic controller electrically connected to the switching network and configured to operate the switching element by providing control signals to the integrated circuit.

9. The motor drive of claim 8, wherein the switching network is a three-phase inverter and includes a plurality of integrated circuits, the plurality of integrated circuits including three high-side switching elements and three low-side switching elements and corresponding plurality of gate drivers, wherein the integrated circuit is one of the plurality of integrated circuits, and wherein the switching element is one of the three high-side switching elements or the three low-side switching elements, and/or
wherein the integrated circuit includes a drain terminal connected to a drain of the switching element, a source terminal connected to a source of the switching element, a control terminal connected to a control input of the gate driver, and a power supply terminal connected to a power supply input of the gate driver, wherein the control terminal is electrically connected to an output pin of the electronic controller, and the power supply terminal is electrically connected to a housekeeping power supply,
preferably wherein the drain terminal is electrically connected to a positive bus of the power bus and the source terminal is electrically connected to a phase terminal of a motor and/or wherein the source terminal is electrically connected to a negative bus of the power bus and the drain terminal is electrically connected to a phase terminal of a motor.

10. The motor drive of claim 8 or 9, wherein the integrated circuit is a first integrated circuit, wherein the switching element is a first high-side wide bandgap semiconductor field effect transistor (FET), wherein the gate driver is a first high-side gate driver,
wherein the switching network is a the three-phase inverter including the first integrated circuit, a second integrated circuit, and a third integrated circuit,
wherein the first integrated circuit further includes a first low-side wide bandgap semiconductor FET and a first low-side gate driver for the first low-side wide bandgap semiconductor FET,
wherein the second integrated circuit includes a second high-side wide bandgap semiconductor FET, a second high-side gate driver for the second high-side wide bandgap semiconductor FET, a second low-side wide bandgap semiconductor FET, and a second low-side gate driver for the second low-side wide bandgap semiconductor FET, and
wherein the third integrated circuit includes a third high-side wide bandgap semiconductor FET, a third high-side gate driver for the third high-side wide bandgap semiconductor FET, a third low-side wide bandgap semiconductor FET, and a third low-side gate driver for the third low-side wide bandgap semiconductor FET,
preferably wherein the first integrated circuit includes a positive bus terminal, a negative bus terminal, a first control terminal for the first high-side gate driver, a second control terminal for the first low-side gate driver, a power supply terminal, and a pole terminal, the first high-side wide bandgap semiconductor FET is connected between the positive bus terminal and the pole terminal and the first low-side wide bandgap semiconductor FET is connected between the pole terminal and the negative bus terminal, and wherein the positive bus terminal is electrically connected to a positive bus of the power bus and the negative bus terminal is electrically connected to negative bus of the power bus.

11. The motor drive of claim 10, further comprises:
input circuitry electrically connected between the electronic controller and the switching network, the input circuitry configured to:
receive control signals from the electronic controller and provide the control signals to the first integrated circuit, the second integrated circuit, and the third integrated circuit.

12. The motor drive of any one of claims 8 to 11, wherein the switching element is a Gallium Nitride Enhancement Mode High Electron Mobility Transistor (GaN E-HEMT), and/or wherein the switching network includes a plurality of integrated circuits connected in parallel between the power bus and one phase terminal of a motor, wherein the plurality of integrated circuits includes the integrated circuit.

13. A power tool comprising:
a brushless direct current (BLDC) motor;
a power input;
a first integrated circuit electrically connected between a phase terminal of the BLDC motor and the power input, the first integrated circuit including a first Gallium Nitride (GaN) field effect transistor (FET) and a first gate driver for the first GaN FET
a second integrated circuit electrically connected between the phase terminal of the BLDC motor and the power input and in parallel with the first integrated circuit, the second integrated circuit including a second GaN FET and a second gate driver for the second GaN FET; and
an input circuit configured to receive a control signal from an electronic controller and provide the control signal to the first integrated circuit and the second integrated circuit.

14. The power tool of claim 13, wherein the first integrated circuit includes a drain terminal connected to a drain of the first GaN FET, a source terminal connected to a source of the first GaN FET, a control terminal connected to a control input of the gate driver, and a power supply terminal connected to a power supply input of the gate driver, wherein the control terminal is configured to receive the control signal from the input circuit, and the power supply terminal is electrically connected to a housekeeping power supply, and/or wherein the GaN FET is a Gallium Nitride Enhancement Mode High Electron Mobility Transistor (GaN E-HEMT).

15. The power tool of claim 14, wherein the drain terminal is electrically connected to a positive bus of the power input and the source terminal is electrically connected to the phase terminal, and/or wherein the source terminal is electrically connected to a negative bus of the power input and the drain terminal is electrically connected to the phase terminal.
